# EUROPEAN PATENT SPECIFICATION

(11) **EP 2 857 547 B1**
(45) Date of publication and mention of the grant of the patent: **23.08.2017**
(21) Application number: 13873045.2
(22) Date of filing: 27.09.2013
(51) Int. Cl.: C23C 14/34, H01F 41/18, H01F 41/02, C23C 14/14, B22F 3/14, B22F 5/00, B22F 9/04, H01F 1/053, B22F 3/15, H01J 37/34

(54) **METHOD FOR MAKING A RARE-EARTH MAGNET SPUTTERING TARGET**
VERFAHREN ZUR HERSTELLUNG EINES SELTENERDMAGNET SPUTTERTARGET
PROCÉDÉ DE PRODUCTION D'UNE CIBLE DE PULVÉRISATION POUR AIMANT EN TERRE RARE

(30) Priority: 28.01.2013 JP 2013012788
(43) Date of publication of application: 08.04.2015
(73) Proprietor: JX Nippon Mining & Metals Corp., Chiyoda-ku Tokyo 100-8164 (JP)
(72) Inventor: SAWATARI, Hironobu, Kitaibaraki-shi Ibaraki 319-1535 (JP)
(74) Representative: Hoarton, Lloyd Douglas Charles
(86) International application number: PCT/JP2013/076186
(87) International publication number: WO 2014/115375

(56) References cited:
- WO-A1-2007/119271
- DE-A1- 19 922 144
- JP-A- H0 499 010
- JP-A- H07 106 179
- JP-A- H09 219 313
- JP-A- H11 288 812
- JP-A- 2000 348 919
- JP-A- 2012 207 274

## Description

### TECHNICAL FIELD

The present invention relates to a sputtering target suitable for producing a rare-earth magnetic film by sputtering or pulse laser deposition and relates a method of producing the sputtering target.

### BACKGROUND ART

In recent years, rare-earth magnets having excellent magnetic characteristics have been being reduced in size and have been improved in performance associated with reductions in size and weight of electronic devices. In particular, neodymium magnets have highest magnetic energy products among present magnets and are therefore expected to be applied to the field of energy, such as Micro Electro Mechanical Systems (MEMS) and energy harvest (environmental power generation), and the field of medical instrument.

The rare-earth magnetic thin films are known that they are formed by sputtering (Patent Literature 1, Non-Patent Literature 1) or physical vapor deposition (PVD) such as pulse laser deposition (Patent Literature 2, Non-Patent Literature 2), and various researches and developments for such films have been conducted. Unfortunately, the rare-earth magnetic thin films formed by these methods have not yet obtained magnetic characteristics compatible to those of bulk magnets and have not been yet commercialized at present.

There are many studies on the mechanism of coercive force of neodymium magnets. For example, it is believed that in order to assure coercive force, it is important to isolate main phases from each other in terms of magnetism by uniformly surrounding the main phase of refined Nd₂Fe₁₄B with a nonmagnetic Nd-rich phase or to reduce the lattice instability at the interface between a main phase and a Nd-rich phase or the reverse magnetic domain that is formed by impurities (Patent Literature 3, Non-Patent Literature 3).

From these viewpoints, the target materials used in production of rare-earth magnetic thin films preferably include fine and uniform crystalline grains having a high purity. Regarding the purity, it is reported that in particular, a gas component, oxygen, highly affects the magnetic characteristics (Patent Literature 4, Non-Patent Literature 4). In addition, since a large variation in the composition of a thin film affects the magnetic characteristics, it is known that it is important to reduce the void and segregation of a target material and to achieve a constant composition ratio of constituent elements in the thickness direction of the target material.

The target material can be produced by a melting process or a sintering process. The melting process can provide a target material having a high purity and a high density, but has a difficulty in control of the grain diameter and composition. Accordingly, the sintering process, which is excellent in control of grain diameter and composition, is usually employed. However, the sintering process requires a large number of production steps compared to the melting process and has a problem in the production steps of easily causing oxygen contamination, which highly affects the magnetic characteristics of rare-earth magnetic thin films. Thus, effective interruption of oxygen contamination has been required.

DE 199 22 144 discloses recovering a valuable composition from a material containing one or more rare earth elements by comminution, followed by acid washing and/or calcium reduction treatment. The initial material is an RE-Fe-B based or Nd-Fe-B based sintered magnet material and the recovered composition is an RE-Fe-B based alloy or an alloy containing a Nd2Fe14B phase.

Patent Literature 1: Japanese Patent Laid-Open Publication No. 2012-207274
Patent Literature 2: Japanese Patent Laid-Open Publication No. 2009-091613
Patent Literature 3: International Patent Publication No. WO2005/091315
Patent Literature 4: Japanese Patent Laid-Open Publication No. 2009-231391
Non-Patent Literature 1: N.M. Dempsey, A. Walther, F. May, D. Givord, K. Khlopkov, and O. Gutfeisch:Appl. Phys. Lett., 90 (2007), 092509-1-092509-3
Non-Patent Literature 2: H. Fukunaga, T. Kamikawatoko, M. Nakano, and T. Yamashita: J. Appl. Phys., 109 (2011), 07A758-1-07A758-3
Non-Patent Literature 3: Kazuhiro Hono, Tadakatsu Ohkubo, and H. Sepehri-Amin, Journal of Japan Institute of Metals, vol. 76, No. 1, p. 2, January, 2012
Non-Patent Literature 4: Yasuhiro Une and Masato Sagawa, Journal of Japan Institute of Metals, vol. 76, No. 1, p. 12, January, 2012

### SUMMARY OF INVENTION

### [Technical Problem]

It is an object of the present invention to provide a sintered compact target that can form rare-earth magnetic thin films, in particular, neodymium magnetic (Nd-Fe-B-based magnetic) thin films, having good magnetic characteristics with excellent mass productivity and reproducibility, and provide a method of producing the sintered compact target.

### [Solution to Problem]

The present inventors have diligently studied for solving the above-described problems and, as a result, have found that the magnetic characteristics of a rare-earth magnetic thin film can be improved by strictly controlling the crystal grain diameter, relative density, compositional variation, and impurity concentration of a target.

On the basis of these findings, the present invention provides a method of producing a rare-earth magnetic target as claimed.

### [Advantageous Effects of Invention]

The present invention allows stable formation of films by sputtering or pulse laser deposition by strictly controlling the crystal grain diameter, relative density, compositional variation, impurity concentration, etc. of a rare-earth magnetic target, and has excellent effects of improving the magnetic characteristics of rare-earth magnetic thin films and increasing the productivity.

### BRIEF DESCRIPTION OF DRAWINGS

[Fig. 1] This is a diagram showing a relationship among sintering pressure, sintering temperature, and sintering characteristics.
[Fig. 2] This is a graph showing the grain size distribution of the atomized powder of Example 1.
[Fig. 3] This is a photograph showing the outside appearance of the sintered compact target of Example 1.
[Fig. 4] This is a graph showing the composition distribution in the thickness direction of the sintered compact target of Example 1.

### DESCRIPTION OF EMBODIMENTS

The rare-earth magnetic target of the present invention comprises neodymium (Nd), iron (Fe), and boron (B) as essential components and can optionally comprise elements that are publicly known as component compositions of rare-earth magnets, for example, rare-earth elements such as Dy, Pr, Tb, Ho and Sm, transition metal elements such as Co, Cu, Cr and Ni, and typical metal elements such as Al.

The target of the present invention is characterized in that the target is constituted of fine and uniform crystalline grains having an average crystal grain diameter of 10 to 200 µm. In general, coercive force is in inverse proportion to the logarithm of square of the crystal grain diameter. Accordingly, a reduction in grain size is effective, and the average crystal grain diameter is reduced to 200 µm or less. The crystalline grains are manufactured by gas atomization having a risk of increasing oxygen content with an increase of the surface area of the gas atomized powder. Accordingly, the average crystal grain diameter is controlled to be 10 µm or more.

The rare-earth magnetic target of the present invention is characterized in that the target has a relative density of 97% or more, preferably 99% or more. Stable deposition by sputtering or pulse laser deposition can be achieved by reducing, for example, voids of the target and increasing the density, and the compositional variations in the resulting thin films can be reduced.

The target of the present invention is also characterized in that the compositional variation of neodymium in the thickness direction is low and, preferably, that the coefficient of variation is 10% or less. Herein, the coefficient of variation is determined by measuring component compositions at a plurality of arbitrary positions along the thickness direction of the target and being calculated from the obtained average value and standard deviation of the neodymium compositions by an expression: coefficient of variation = (standard deviation)/(arithmetic mean value) × 100 (%). The control of the thus-calculated coefficient of variation to 10% or less can also reduce the compositional variation in a rare-earth magnetic thin film and can prevent the deterioration of magnetic characteristics.

The target of the present invention is further characterized in that the target is a high-purity target having a low impurity content, in particular, that the content of oxygen, which is a gas component, is 1000 wtppm or less.

It is known that among gas components, oxygen considerably affects magnetic characteristics. Accordingly, stable and good magnetic characteristics can be provided by reducing the oxygen content as much as possible.

The rare-earth magnetic target of the present invention can be produced by, for example, as follows.

Neodymium (Nd) and iron (Fe) each having a purity of 3N5 (99.95%) or more, preferably 4N (99.99%) or more, and more preferably 4N5 (99.995%) or more and boron (B) or ferroboron having a purity of 3N (99.9%) or more are prepared as essential raw materials.

An alloy ingot is then produced by melting and casting the raw materials in a high vacuum of about 2×10⁻⁴ Torr or less. The alloy ingot is then re-melted, followed by gas atomization in an inert gas to produce a fine powder. Subsequently, the thus-prepared fine powder is sintered by hot pressing or hot isostatic pressing into a sintered compact. The sintered compact is machined by, for example, surface polishing into a rare-earth magnetic target for forming thin films.

In the melting and casting in above, a cold crucible melting process using a water-cooled copper crucible is desirably employed. This melting process can prevent impurity contamination from a crucible, compared to a vacuum induction heating using an ordinary magnesium crucible or aluminum crucible, and can produce an ingot having a high purity.

In the production of a fine powder, as described above, it is preferred to employ a gas atomizing method involving rapid solidification by high speed jetting of an inert gas from a nozzle in an inert gas atmosphere. The residual oxygen in the atmosphere tends to form a native oxide film on the surface of the fine grain during the rapid solidification. It is therefore important to perform vacuuming immediately after the input of the raw materials in an atomization apparatus, and then introduce an inert gas.

The inert gas herein can be nitrogen gas, argon gas, helium gas, or a gas mixture thereof. The average crystal grain diameter can be controlled to 10 to 200 µm by varying the pressure of the gas jetted at a high speed in the gas atomization apparatus from 0.5 to 2 MPa. The average crystal grain diameter herein refers to the 50% cumulative diameter of measured grain size distribution.

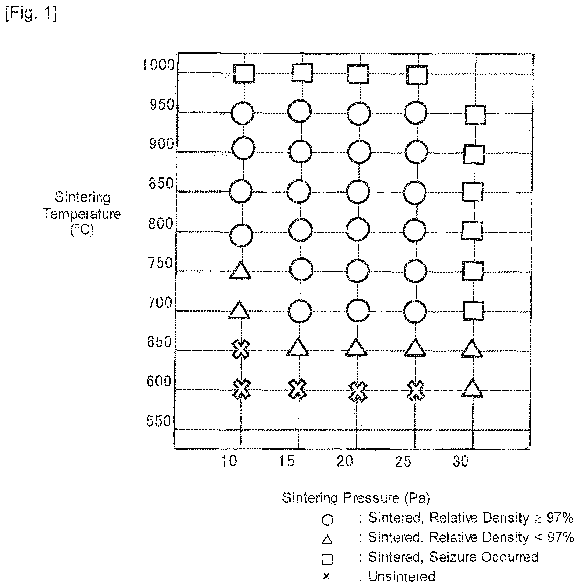

Subsequently, the resulting fine powder is sintered by hot pressing or hot isostatic pressing. In order to prevent contamination with oxygen, the sintering is performed in an inert atmosphere or in a high vacuum of about 5×10⁻⁴ Torr or less. Regarding sintering conditions, when the pressure was 15 MPa, a temperature of 600°C left an unsintered portion, whereas a temperature of 650°C or more realized complete sintering. However, partial seizure occurs in the mold by increasing the sintering temperature and the sintering pressure. The pressure not causing seizure at a temperature of 950°C was 25 MPa. The sintering conditions that allow sintering not causing seizure and providing a relative density of 97% or more are a temperature of 700°C or more and 950°C or less and a pressure of 10 MPa or more and 25 MPa or less as shown in Fig. 1.

The resulting sintered compact is machined by, for example, grinding or polishing into a target form suitable for a use. The resulting target can be used for forming rare-earth magnetic thin films by sputtering or pulse laser deposition.

### [Examples]

The present invention will now be described on the basis of an Example and a Comparative Example. The Example is merely illustrative, and the invention is not intended to be limited thereby. That is, the present invention is limited only by the claims and includes various modifications within the scope of the present invention in addition to the following Example.

### (Example 1)

Neodymium having a purity of 3N5, iron having a purity of 4N, and ferroboron having a purity of 2N were prepared as raw materials. All the raw materials were in block forms. These materials were weighed to give a composition of Nd15-Fe75-B10. The materials were then fed into a cold crucible furnace as a water-cooled copper crucible, and subjected to melting in a vacuum of 1×10⁻⁴ Torr at 1320°C for 60 minutes or more to produce about 6 kg of an alloy ingot.

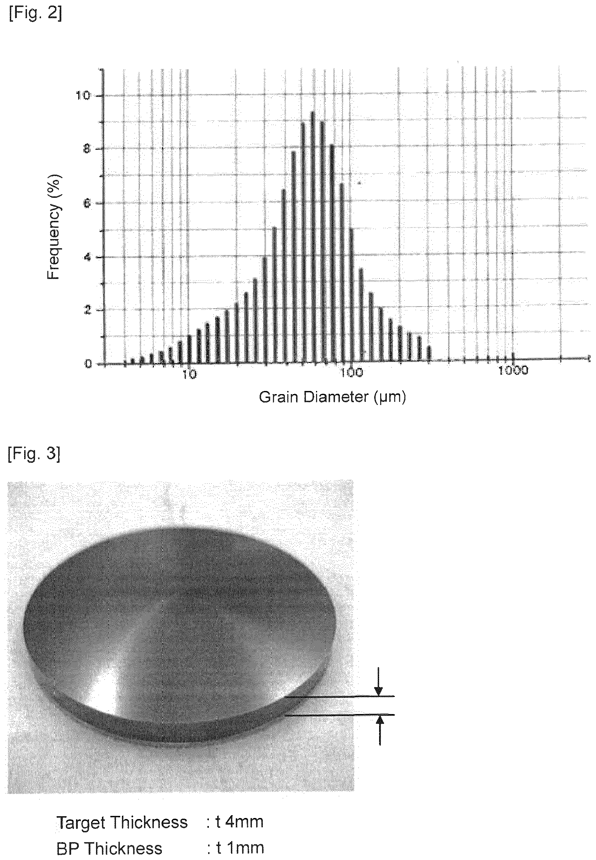

Subsequently, the upper, bottom, and side portions of the ingot were ground and was then cut into blocks. The blocks were fed in a gas atomization apparatus. The apparatus was evacuated to 1×10⁻² Torr, and an inert gas was then introduced into the apparatus. The temperature of the apparatus was increased to 1420°C and was maintained for about 10 minutes. Subsequently, an inert gas was jetted at about 1.5 MPa to the dropped molten metal to give a fine powder having an average grain diameter of about 60 µm as shown in Fig. 2.

Subsequently, the fine powder was charged in a mold for pressing, was applied with a pressure of 15 MPa in a vacuum atmosphere, and was sintered at a temperature of 900°C for 2 hours, followed by cooling to ordinary temperature. The side portions and the upper and bottom surfaces of the resulting sintered compact were ground and polished into a disk-shaped target having a diameter of 76 mm and a thickness of 4 mm as shown in Fig. 3. The average crystal grain diameter of the target was about 70 µm in observation with an SEM. The relative density of the target material measured by an Archimedes method was 99%.

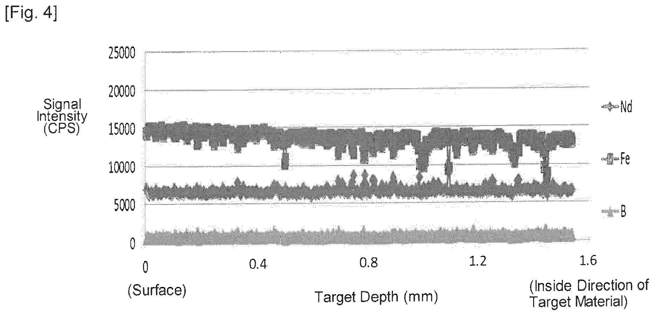

Subsequently, the compositional variations of Nd, Fe, and B in the thickness direction of the resulting target were measured with an EPMA within a range of 1.54 mm from the surface at 4-µm intervals. The results are shown in Fig. 4. Herein, in measurement with the EPMA, the disk-shaped target material was cut in the thickness direction, and the compositional variation of each compositional element in the thickness direction was observed by irradiating the cut plane with electronic beams and scanning the cut plane in the depth direction. The results in the target material of Example 1 were that the coefficient of variation of the Nd composition was 8.0%, the coefficient of variation of the Fe composition was 7.8%, and the coefficient of variation of the B composition was 8.5%. Thus, the coefficient of variation of each compositional element was small, and it was demonstrated that the target material was excellent in homogeneity of each component composition. The results of measurement of the gas component concentrations of the target by an LECO method were that the oxygen concentration was 920 ppm, the carbon concentration was 750 ppm, the nitrogen concentration was 10 ppm, and the hydrogen concentration was 50 ppm. Thus, low gas component concentrations could be achieved.

Subsequently, the target was attached to a backing plate, and a Ta buffer layer, a NdFeB layer (40 nm), and a Ta cap layer were continuously formed by sputtering at an Ar pressure of 1×10⁻² Torr on a Si substrate provided with a thermal oxide film. A Ta layer was separately formed using a tantalum target. The B-H curve of the rare-earth magnetic thin film showed a coercive force of 1.1 T. Thus, good magnetic characteristics were achieved.

### (Comparative Example 1)

A target was produced by a melting process, unlike Example 1. Neodymium having a purity of 3N5, iron having a purity of 4N, and ferroboron having a purity of 2N were prepared as raw materials, and were weighed to give a composition of Nd15-Fe75-B10. The materials were then fed into a cold crucible furnace as a water-cooled copper crucible, and subjected to melting in a vacuum of 1×10⁻⁴ Torr at 1320°C for 60 minutes or more to produce about 6 kg of an alloy ingot. In order to prevent microcracking in the ingot, the alloy ingot was cooled by furnace cooling. Subsequently, the upper, bottom, and side portions of the ingot were ground, and the side portions and the upper and bottom surfaces were then ground and polished into a disk-shaped target having a diameter of 76 mm and a thickness of 4 mm. The average crystal grain diameter of the target was about 210 µm in observation with an SEM as in Example 1. The relative density of the target material measured by an Archimedes method was 100%.

Furthermore, the compositional variations of Nd, Fe, and B in the thickness direction of the resulting target were measured as in Example 1 with an EPMA within a range of 1.54 mm from the surface at 4-µm intervals. The results in the target material of Comparative Example 1 were that the coefficient of variation of the Nd composition was 30%, the coefficient of variation of the Fe composition was 32%, and the coefficient of variation of the B composition was 35%. Thus, the compositions significantly varied compared to those in the target material produced by the sintering process. The results of measurement of the gas component concentrations of the target by an LECO method were that the oxygen concentration was 340 ppm, the carbon concentration was 120 ppm, the nitrogen concentration was 10 ppm, and the hydrogen concentration was 40 ppm. Thus, gas components were contained therein.

Subsequently, the target was attached to a backing plate, and a Ta buffer layer, a NdFeB layer (40 nm), and a Ta cap layer were continuously formed as in Example 1 on a Si substrate provided with a thermal oxide film to form a rare-earth magnetic thin film. The B-H curve of the rare-earth magnetic thin film showed a coercive force of 0.7 T. Thus, good magnetic characteristics were not achieved.

### INDUSTRIALAPPLICABILITY

The sintered compact target of the present invention can form a high-quality rare-earth magnetic thin film having good magnetic characteristics by sputtering or pulse laser deposition and is therefore useful in the field of energy, such as Micro Electro Mechanical Systems (MEMS) and energy harvest (environmental power generation), and the field of medical instrument.

## Claims

1. A method of producing a rare-earth magnet target consisting of neodymium, iron, and boron, the method comprising:
producing an alloy ingot by melting and casting a raw material including neodymium, iron, and boron as main components in a vacuum;
finely pulverizing the alloy ingot by a gas atomizing method using an inert gas; and
sintering the resulting fine powder by hot pressing or hot isostatic pressing, wherein the sintering is performed at a sintering pressure of 10 MPa or more and 25 MPa or less and a sintering temperature of 700°C or more and 950°C or less,
wherein the raw material is melted by a cold crucible melting process using a water-cooled copper crucible.

2. The method of claim 1, wherein the raw materials comprise:
neodymium (Nd) and iron (Fe) each having a purity of 99.95% (3N5) or more, preferably 99.99% (4N) or more, and more preferably 99.995% (4N5) or more and boron (B) or ferroboron having a purity of 99.9% (3N) or more.

3. The method of claim 1 or 2, wherein the sintering is performed in a vacuum of 0.06666 Pa, 5×10⁻⁴ Torr or less.

4. The method of claim 1, 2 or 3, wherein the gas atomizing further comprises:
varying the pressure of the gas from 0.5 to 2 MPa.

## Patentansprüche

1. Verfahren zur Herstellung eines Seltenerdmagnet-Targets bestehend aus Neodym, Eisen und Bor, wobei das Verfahren Folgendes umfasst:
Herstellung eines Legierungsblocks durch Schmelzen und Gießen eines Rohmaterials einschließlich Neodym, Eisen und Bor als Hauptkomponenten in einem Vakuum;
Feinpulverisieren des Legierungsblocks durch ein Gasatomisierungsverfahren unter Verwendung eines Inertgases; und
Sintern des resultierenden Feinpulvers durch Heißpressen oder heißisostatisches Pressen, worin das Sintern bei einem Sinterdruck von 10 MPa oder mehr und 25 MPa oder weniger und einer Sintertemperatur von 700 °C oder mehr und 950 °C oder weniger durchgeführt wird,
worin das Rohmaterial durch einen Kalttiegel-Schmelzvorgang unter Verwendung eines wassergekühlten Kupfertiegels geschmolzen wird.

2. Verfahren nach Anspruch 1, worin die Rohmaterialien Folgendes umfassen:
Neodym (Nd) und Eisen (Fe) jeweils mit einer Reinheit von 99,95 % (3N5) oder mehr, vorzugsweise 99,99 % (4N) oder mehr und bevorzugter 99,995 % (4N5) oder mehr und Bor (B) oder Ferro-Bor mit einer Reinheit von 99,9 % (3N) oder mehr.

3. Verfahren nach Anspruch 1 oder 2, worin das Sintern in einem Vakuum von 0,06666 Pa, 5×10⁻⁴ Torr oder weniger durchgeführt wird.

4. Verfahren nach Anspruch 1, 2 oder 3, worin das Gasatomisieren ferner Folgendes umfasst:
Variieren des Drucks des Gases von 0,5 bis 2 MPa.

## Revendications

1. Procédé de production d'une cible aimantée aux terres rares, constituée de néodyme, de fer et de bore, le procédé consistant à :
produire un lingot en alliage en fondant et en coulant sous vide une matière première comprenant du néodyme, du fer et du bore en guise de composants principaux ;
pulvériser finement le lingot en alliage par un procédé d'atomisation gazeuse au moyen d'un gaz inerte ; et
fritter la poudre fine résultante par pressage à chaud ou pressage isostatique à chaud, le frittage étant réalisé à une pression de frittage supérieure ou égale à 10 MPa et inférieure ou égale à 25 MPa et à une température de frittage supérieure ou égale à 700 °C et inférieure ou égale à 950 °C,
la matière première étant fondue par un procédé de fusion à froid au creuset au moyen d'un creuset en cuivre refroidi à l'eau.

2. Procédé selon la revendication 1, dans lequel la matière première comprend :
du néodyme (Nd) et du fer (Fe) ayant chacun une pureté supérieure ou égale à 99,95 % (3N5), de préférence supérieure ou égale à 99,99 % (4N), et plus préférablement supérieure ou égale à 99,995 % (4N5), et du bore (B) ou du ferrobore ayant une pureté supérieure ou égale à 99,9 % (3N).

3. Procédé selon la revendication 1 ou 2, dans lequel le frittage est réalisé sous vide à une pression inférieure ou égale à 0,06666 Pa, 5×10⁻⁴ Torr.

4. Procédé selon la revendication 1, 2 ou 3, dans lequel l'atomisation gazeuse consiste à :
faire varier la pression du gaz de 0,5 à 2 MPa.
